# EUROPÄISCHE PATENTSCHRIFT

(11) **EP 4 145 164 B1**
(45) Veröffentlichungstag und Bekanntmachung des Hinweises auf die Patenterteilung: **15.11.2023**
(21) Anmeldenummer: 22190292.7
(22) Anmeldetag: 12.08.2022
(51) Int. Cl.: G01R 33/30

(54) **KUPPLUNGSEINRICHTUNG FÜR EINE NMR-DURCHFLUSSZELLE ZUR VOM MAGNETFELD UNABHÄNGIGEN AUSRICHTUNG UND NMR-SPEKTROMETER**
COUPLING DEVICE FOR NMR FLOW CELL FOR MAGNETIC FIELD INDEPENDENT ALIGNMENT AND NMR SPECTROMETER
DISPOSITIF DE COUPLAGE POUR UNE CELLULE D'ÉCOULEMENT RMN DESTINÉ À L'ALIGNEMENT INDÉPENDANT DU CHAMP MAGNÉTIQUE ET SPECTROMÈTRE RMN

(30) Priorität: 03.09.2021 DE 102021209738
(43) Veröffentlichungstag der Anmeldung: 08.03.2023
(73) Patentinhaber: Bruker Switzerland AG, 8117 Fällanden (CH)
(72) Erfinder: Meister, Roger, 8132 Hinteregg (CH); Woodtli, Martin, 8617 Mönchaltdorf (CH)
(74) Vertreter: Kohler Schmid Möbus Patentanwälte

(56) Entgegenhaltungen:
- US-A- 4 827 761
- US-A1- 2006 091 885

## Beschreibung

Die Erfindung betrifft eine Durchflusszellenbaugruppe zur Nutzung in einem NMR-Spektrometer für die Durchführung von NMR-Messungen an einer flüssigen NMR-Probe, umfassend
- eine Flusszelle zur Aufnahme der NMR-Probe, wobei die Flusszelle eine erste Öffnung an einem ersten Ende der Flusszelle und eine zweite Öffnung an einem zweiten Ende ausbildet, und wobei die Flusszelle entlang einer longitudinalen Achse im Wesentlichen zylinderförmig ist, und
- ein Anschlussstück für die fluiddichte Verbindung einer Durchflussleitung mit der Flusszelle, wobei das Anschlussstück bei der ersten Öffnung der Flusszelle angeordnet ist,
wobei ein Dichtungskopf des Anschlussstücks in der ersten Öffnung der Flusszelle angeordnet ist, und wobei ein Dichtungskopfdurchmesser d_{dicht} des Dichtungskopfes des Anschlussstücks größer ist als ein Öffnungsdurchmesser d_{off} der ersten Öffnung der Flusszelle.

Eine solche Durchflusszellenbaugruppe ist aus der Druckschrift US 4 827 761 A (=Referenz [0]) bekannt geworden.

Eine ähnliche Durchflusszellenbaugruppe ist in der US 2006 / 0 091 885 A1 (=Referenz [1]) beschrieben.

### Hintergrund der Erfindung

Die vorliegende Erfindung befasst sich ganz allgemein mit dem Bereich der Kernspinresonanz (nuclear magnetic resonance = "NMR"), insbesondere mit Durchflusszellenbaugruppen für NMR-Messungen, durch welche während einer NMR-Messung eine flüssige NMR-Probe geleitet wird.

Die NMR-Spektroskopie findet als leistungsfähiges Verfahren in der instrumentellen Analytik weitverbreitete Verwendung. Durch die NMR-Spektroskopie kann von einer zu untersuchenden Substanz, wie etwa einer metallorganischen Verbindung oder einem Biomolekül, die elektronische Umgebung einzelner Atome und deren Wechselwirkung mit den Nachbaratomen untersucht werden. Hierdurch können beispielsweise die Struktur, Dynamik und Zusammensetzung der zu untersuchenden Substanz aufgeklärt und die Konzentration der zu untersuchenden Substanz bestimmt werden.

In der Regel wird die zu untersuchende Substanz in flüssiger Form in ein Probenröhrchen gefüllt, welches im Wesentlichen zylindrisch ist. Das gefüllte Probenröhrchen wird zur Messung in den Messbereich eines NMR-Probenkopfs eines NMR-Spektrometers platziert. Die Substanz ist dort einem starken statischen Magnetfeld B₀ ausgesetzt, wodurch die Kernspins in der Substanz ausgerichtet werden. In die zu untersuchende Substanz werden dann hochfrequente elektromagnetische Impulse eingestrahlt. Die hierbei erzeugten hochfrequenten elektromagnetischen Felder werden im NMR-Spektrometer detektiert. Daraus können dann Informationen über die Eigenschaften der untersuchten Substanz gewonnen werden.

Bei der Messung flüssiger Probensubstanzen über NMR können unterschiedliche Ziele im Vordergrund stehen. Einerseits kann ein Bedarf dafür bestehen, viele NMR-Proben hintereinander zu messen. Üblicherweise wird diese Aufgabe dadurch gelöst, dass die flüssige Probensubstanz in ein NMR-Probenröhrchen gefüllt wird, dieses NMR-Röhrchen durch einen Verschlussstopfen oder durch Verschmelzen der Öffnung verschlossen wird und anschließend in den NMR-Probenkopf des NMR-Spektrometers eingeführt wird. Die NMR-Messung wird sodann durchgeführt und anschließend das NMR-Röhrchen wieder aus dem NMR-Spektrometer entfernt. Für jede weitere zu messende NMR-Probe wird dieser Ablauf wiederholt. Es handelt sich also um einen relativ zeit- und arbeitsintensiven Messprozess.

Andererseits kann es von großem Interesse sein, chemische Reaktionen in Echtzeit per NMR-Messung zu verfolgen. Dies ist jedoch mit klassischen NMR-Probenröhrchen so gut wie gar nicht erfüllbar. Entsprechend der verwendeten Substanzen können chemische Reaktionen innerhalb weniger Millisekunden bereits komplett abgelaufen sein oder aber auch mehrere Stunden andauern. Bei kurzzeitig ablaufenden Reaktionen ist der Experimentator oft chancenlos, schnell genug die Substanzen in das NMR-Probenröhrchen zu füllen, dieses zu verschließen, in das NMR-Spektrometer einzusetzen und eine NMR-Messung zu starten, um die Reaktion in Echtzeit nachzuverfolgen. Bei sehr langsam ablaufenden Reaktionen ist es hingegen oft notwendig, eine gute und permanente Durchmischung der unterschiedlichen Substanzen zu gewährleisten, damit die chemische Reaktion halbwegs einheitlich und reproduzierbar ablaufen kann.

Eine Möglichkeit, um die oben genannten Ziele erreichen zu können, ist die Verwendung einer sogenannten Durchflusszelle als NMR-Probenbehälter. Diese wird in den NMR-Probenkopf des NMR-Spektrometers eingesetzt und beinhaltet Zuleitungen, mit denen eine flüssige NMR-Probe zugeführt und wieder abgeführt werden kann. Solche Durchflusszellen wurden bereits in der Fachliteratur beschrieben.

So ist in der US 2016 / 0 290 941 A1 (=Referenz [2]) eine Überwachungszelle beschrieben worden, mit der eine NMR-Messung einer Reaktionsflüssigkeit durchgeführt werden kann. Die Überwachungszelle umfasst eine hohle NMR-Sonde, die mit einer zu messenden NMR-Probe befüllt wird und nur an einem Ende offen ist. Die hohle NMR-Sonde ist an dem offenen Ende über einen Adapter mit der restlichen Überwachungszelle verbunden und kann bei Bedarf ausgetauscht werden. Eine Kapillare zur Zuführung der flüssigen Probe ragt in die hohle NMR-Sonde ein. Die flüssige Probe wird von der offenen Seite zu-und abgeführt. Wird die Überwachungszelle in ein NMR-Spektrometer eingesetzt, bei dem das Magnetfeld im Messbereich parallel zur Kapillare der hohlen NMR-Sonde der Überwachungszelle steht, werden die NMR-Messungen nicht gestört. Bei NMR-Spektrometern, bei denen das Magnetfeld im Messbereich hingegen nicht parallel sondern beispielsweise rechtwinklig zur Kapillare der hohlen NMR-Sonde der Überwachungszelle steht, stört die Kapillare. Die Störung kommt dadurch zustande, dass die Kapillare das homogen und parallel verlaufende Magnetfeld im Bereich, in dem die Kapillare durch das Magnetfeld stößt, verschiebt, respektive krümmt. Der Einfluss der Kapillare auf das Magnetfeld kann durch Shimmen nicht ausreichend ausgeglichen werden, wodurch eine NMR-Messung zwar möglich ist, die Resultate aber absolut unbrauchbar und nicht interpretierbar sind. Die in Referenz [2] beschriebene Überwachungszelle kann also nur in NMR-Spektrometern eingesetzt werden, deren Magnetfeld parallel zur Kapillare der hohlen NMR-Sonde verläuft.

Weiterhin wird in der US 2005 / 0 052 184 A1 (=Referenz [3]) ein NMR-Flusszellenaufbau beschrieben, der eine Flusszelle, eine Zulaufleitung sowie eine Ablaufleitung umfasst. Zulaufleitung und Ablaufleitung befinden sich jeweils an einem oberen Ende und an einem unteren Ende der Flusszelle und sind jeweils über ein Anschlussstück mit der Flusszelle verbunden. Hierzu werden die Enden der Flusszelle, die Zulaufleitung und die Ablaufleitung in das Anschlussstück eingeschoben und durch Verkleben befestigt. Die flüssige NMR-Probe fließt nur in eine Richtung durch die Flusszelle. Nachteilig an diesem Flusszellenaufbau ist, dass die Flusszelle beispielsweise bei einer Beschädigung oder Verunreinigung wegen der festen Verklebung nicht einfach ausgetauscht werden kann. Die verklebte Zu- und Ablaufleitung müssen ebenfalls ausgetauscht werden. Eine Wiedernutzung des Flusszellenaufbaus wird dadurch erschwert oder gar unmöglich.

In der US 6 396 274 B1 (=Referenz [4]) wird ein NMR-Probenkopf vorgestellt, der sowohl für Messungen mit einem einfachen NMR-Probenröhrchen wie auch für Messungen mit eine Flusszelle geeignet ist. Weiterhin werden Anschlüsse beschrieben, mit denen eine flüssige Probensubstanz von einem unteren Ende einer in den NMR-Probenkopf eingesetzten Flusszelle zu einem oberen Ende der Flusszelle geführt wird. Wie die Flusszelle mit den Anschlüssen im Detail ausgestaltet ist, wird in Referenz [4] nicht beschrieben.

Bei den Durchflusszellenbaugruppen "InsightMR" der Bruker Corporation, Billerica, Massachusetts, USA (=Referenz [5]) und Insight 2.0 der Bruker Corporation, Billerica, Massachusetts, USA (=Referenz [6]) wird mittels einer in ein NMR-Probenröhrchen einragenden Kapillare die flüssige NMR-Probe in das NMR-Probenröhrchen geleitet. Die NMR-Probenröhrchen sind an einer Seite abgeschlossen, weshalb die Probensubstanz an der gleichen Seite abgeführt wird, an der sie zugeführt wurde. Es ergeben sich dabei ähnliche Schwierigkeiten, wie sie bereits hinsichtlich Referenz [2] beschrieben wurden. Die Durchflusszellenbaugruppen können nur in NMR-Spektrometern eingesetzt werden, deren Magnetfeld jeweils parallel zur Kapillare der hohlen NMR-Sonde verläuft.

Ebenfalls bekannt geworden ist eine Durchflusszellenbaugruppe der Firma Magritek GmbH, Aachen, Nordrhein-Westfalen, DE (=Referenz [7]). Diese Durchflusszellenbaugruppe umfasst eine Durchflusszelle, bei der an einem Ende eine Kapillare eingesteckt ist. Die Kapillare wird dabei in eine Verengung der Flusszelle gesteckt. Die Verbindung von Flusszelle und Kapillare erfolgt durch einen reinen Kraftschluss. Die flüssige NMR-Probe fließt nur in eine Richtung durch die Flusszelle. Problematisch bei dieser Durchflusszellenbaugruppe ist jedoch, dass die Verbindung nur gesteckt ist und ausschließlich durch Reibkraft in Position gehalten wird. Daher kann bei höheren Drücken (meist ab 2 bar) in der Flusszelle die Dichtheit der Durchflusszellenbaugruppe leiden und die Verbindung kann sich im Extremfall bei hohen Drücken in der Flusszelle komplett lösen.

In der JP 2003 075 523 A (=Referenz [8]) ist eine Verbindungsstruktur zum stabilen Pressen und Versiegeln eines nicht-magnetischen Probenröhrchens sowie eines Zufuhrröhrchens zur Messung einer Probe in einem starken Magnetfeld unter hohem Druck und hoher Temperatur beschrieben.

Aus der DE 10 2017 120 510 B3 (=Referenz [9]) ist eine druckstabile 3D gedruckte NMR-Durchflusszelle für die NMR-Spektroskopie bekannt. Diese umfasst einen kreiszylindrischen Grundkörper mit einer Keramik sowie gegenüberliegende Aufnahmen für jeweils eine Kapillare, wobei die Kapillaren mit dem Grundkörper im Sinne eines Explosionsschutzes unfehlbar stoffschlüssig verbunden sind.

Die eingangs zitierte Referenz [1] offenbart eine Möglichkeit, eine Durchflusszellenbaugruppe zur Nutzung in einem NMR-Spektrometer für NMR-Messungen zu bauen, mit der die flüssige NMR-Probe eine Flusszelle nur einmal von einem Ende der Flusszelle zum anderen Ende der Flusszelle durchströmt. Im Messbereich der Flusszelle ist keine Kapillare zum Zuführen oder Abführen der flüssigen Probensubstanz angeordnet. Die Durchflusszellenbaugruppe umfasst eine Flusszelle und jeweils ein Anschlussstück an den Enden der Flusszelle. Über die Anschlussstücke kann eine Zulaufkapillare und eine Ablaufkapillare für die flüssige Probensubstanz mit der Flusszelle verbunden werden. An den Enden der Flusszelle befinden sich jeweils Nuten, über die ein Haltering und ein aufweitbares Ende des Anschlussstücks geschoben wird, wodurch das Anschlussstück fest mit dem jeweiligen Ende der Flusszelle verbunden wird. Dann wird eine Zulaufkapillare oder eine Ablaufkapillare, die jeweils ein Verbindungsstück mit einem verjüngten Bereich und einer Druckfeder umfassen, in das entsprechende Anschlussstück eingeführt, fixiert und auf diese Weise mit der Flusszelle verbunden.

Nachteilig an dieser bekannten Durchflusszellenbaugruppe ist, dass das Material des aufweitbaren Endes des Anschlussstücks bei häufigem Gebrauch und längerer Nutzungsdauer Ermüdungserscheinungen zeigen und im schlimmsten Fall brechen kann. Gleiches gilt für das Verbindungsstück der Zulaufkapillare oder der Ablaufkapillare. Bei häufigem Gebrauch kann das Material der Druckfeder Ermüdungserscheinungen zeigen und im schlechtesten Fall versagen. Ebenso besteht die Gefahr, dass sich bei Messungen mit hohen Drücken in der Flusszelle das Verbindungsstück vom Anschlussstück lösen kann.

### Aufgabe der Erfindung

Der vorliegenden Erfindung liegt demgegenüber die Aufgabe zugrunde, eine generische Durchflusszellenbaugruppe der eingangs beschriebenen Art für eine NMR-Messung einer flüssigen NMR-Probe mit möglichst einfachen technischen Mitteln so zu modifizieren, dass die Durchflussleitungen in einfacher Weise auswechselbar sind. Mit Hilfe dieser modifizierten Durchflusszellenbaugruppe sollen dann qualitativ hochwertige NMR-Durchflussmessungen durchgeführt werden können, die von der Ausrichtung des Magnetfeldes in einem NMR-Spektrometer unabhängig sind.

### Kurze Beschreibung der Erfindung

Diese Aufgabe wird durch die vorliegende Erfindung auf ebenso überraschend einfache wie wirkungsvolle Weise dadurch gelöst, dass die hohlzylinderförmige Flusszelle einen Querschnitt aufweist, der sich im Bereich der ersten Öffnung entlang der longitudinalen Achse kontinuierlich verjüngt, sodass der Öffnungsdurchmesser d_{off} der ersten Öffnung der Flusszelle kleiner ist als ein innerer Flusszellendurchmesser dᵢₙₙ.

Die vorliegende Erfindung schlägt vor, den Öffnungsdurchmesser d_{off} der ersten Öffnung der Flusszelle kleiner auszugestalten als den inneren Flusszellendurchmesser dᵢₙₙ. Die Flusszelle erfährt eine Verjüngung in Richtung der ersten Öffnung. Typischerweise gilt für den Öffnungsdurchmesser d_{off} : d_{off} = 0,9*dᵢₙₙ , bevorzugt d_{off} = 0,8*dᵢₙₙ , besonders bevorzugt d_{off} = 0,7*dᵢₙₙ beträgt. Anschließend wird das Anschlussstück mit dem Dichtungskopf, der den Dichtungskopfdurchmesser d_{dicht} aufweist, in die Flusszelle eingeführt. Der Dichtungskopf ist in der Flusszelle positioniert, während der restliche Teil des Anschlusskopfs außerhalb der Flusszelle vorliegen kann.

Da der Dichtungskopfdurchmesser d_{dicht} des Dichtungskopfes größer ist als der Öffnungsdurchmesser d_{off} der ersten Öffnung der Flusszelle, kann der Dichtungskopf und damit auch das Anschlussstück auf einfache und effektive Weise durch die Verjüngung an der ersten Öffnung der Flusszelle in Position gehalten werden. Durch die auf diese Weise erreichte Versperrung der relativen Bewegung von Flusszelle und Anschlussstück in jede Richtung außer der Einführungsrichtung des Anschlussstücks entsteht ein Formschluss. Mit Hilfe des Formschlusses kann das Anschlussstück stabil in Position gehalten werden und gegen ein Verrutschen in der Flusszelle sowie gegen ein Herausrutschen aus der Flusszelle gesichert werden.

Die zweite Öffnung am zweiten Ende der Flusszelle muss groß genug sein, damit das Anschlussstück über die zweite Öffnung in die Flusszelle eingeführt werden kann. Nach dem Einführen des Anschlussstücks kann die zweite Öffnung beispielsweise mit einem Anschluss verbunden werden, über den eine flüssige NMR-Probe aus der Flusszelle wieder abgeführt werden kann.

Die Flusszelle ist im Wesentlichen hohlzylindrisch entlang einer longitudinalen Achse ausgebildet. Die hohlzylindrische Ausgestaltung der Flusszelle ermöglicht einen guten Durchfluss der flüssigen NMR-Probe durch die Flusszelle bei einer gleichzeitig stabilen Struktur der Zelle.

Das Anschlussstück verfügt über eine Innenleitung. Vermittels des Anschlussstückes kann eine Durchflussleitung (z. B. eine Kapillare) über die Innenleitung mit der Flusszelle auf einfache Weise (z. B. durch Einführen der Durchflussleitung in das Anschlussstück) verbunden werden, beispielsweise durch einen Schraubring, der auf das Anschlussstück aufgeschraubt wird, wodurch die Durchflussleitung am Anschlussstück fixiert wird. Eine dauerhaft feste Verbindung zwischen Durchflussleitung und Flusszelle ist nicht nötig. Während einer NMR-Messung kann durch die Durchflussleitung die zu untersuchende, flüssige NMR-Probe über das Anschlussstück bei der ersten Öffnung der Flusszelle in die Flusszelle geleitet werden. Die flüssige NMR-Probe durchströmt die Flusszelle und kann an der zweiten Öffnung der Flusszelle abgeführt werden (beispielsweise in ein Reaktionsgefäß oder ein Entsorgungsgefäß). Nach dem Ende der Messung kann die Durchflussleitung vom Anschlussstück ebenso einfach wieder getrennt und eine andere Durchflussleitung angeschlossen werden, um beispielsweise eine weitere Messung mit einer anderen flüssigen NMR-Probe durchzuführen oder um die Flusszelle mit Hilfe eines Lösemittels zu reinigen.

Wie bereits oben erwähnt, wird die flüssige NMR-Probe bei der ersten Öffnung der Flusszelle in die Flusszelle eingebracht und bei der zweiten Öffnung der Flusszelle wieder abgeführt. Die flüssige NMR-Probe durchströmt die Flusszelle also ausschließlich in eine Richtung. Bei dieser Ausgestaltung der Durchflusszellenbaugruppe besteht keine Notwendigkeit, die Durchflussleitung weit in die Flusszelle hineinragen zu lassen, um eine gute Durchmischung und einen beständigen Strom der flüssigen NMR-Probe zu gewährleisten. Die Durchflusszelle beinhaltet im Bereich der Messung eines NMR-Spektrometers lediglich die flüssige NMR-Probe und keine Zulauf- oder Abflussleitungen. Hierdurch können NMR-Messungen auch an NMR-Spektrometer durchgeführt werden, bei denen das Magnetfeld im Bereich der Messung nicht zwangsweise parallel zur longitudinalen Achse der Flusszelle steht.

Der Formschluss zwischen Anschlussstück und Flusszelle ermöglicht weiterhin eine gute Beständigkeit gegen den Druck, der durch die einfließende flüssige NMR-Probe auf das Anschlussstück ausgeübt wird. Durch den Formschluss kann ein räumliches Verrutschen des Anschlussstücks auf Grund eines hohen Drucks vermieden werden. Weiterhin können durch den Formschluss zwischen Anschlussstück und Flusszelle bei großen Drücken Lecks vermieden werden, so dass die flüssige NMR-Probe auf der Seite der ersten Öffnung der Flusszelle austritt.

Die Wände der Flusszelle sind typischerweise aus Borosilicatglas 3.3 gefertigt. Das Anschlussstück ist typischerweise aus PCTFE (Polychlortrifluorethylen) hergestellt.

### Bevorzugte Ausführungsformen und Weiterbildungen der Erfindung

Bei ganz besonders bevorzugten Ausführungsformen der erfindungsgemäßen Durchflusszellenbaugruppe ist vorgesehen, dass eine Außenkontur des Dichtungskopfes im Wesentlichen einer Innenkontur der Flusszelle im Bereich der ersten Öffnung gleicht.

Hierdurch kann ein passgenauer Formschluss zwischen dem Dichtungskopf und der Flusszelle erreicht werden. Der Dichtungskopf und damit das Anschlussstück können so noch stabiler in Position gehalten und ein Verrutschen des Anschlussstücks vermieden werden. Außerdem kann das Anschlussstück auch bei großen Drücken verwendet werden. Die Wahrscheinlichkeit einer Leckage zwischen dem Dichtungskopf und der Flusszelle kann ebenfalls verringert werden. Die Außenkontur und die Innenkontur können beispielsweise halbrund oder kegelstumpfförmig ausgebildet sein.

Eine bevorzugte Klasse von Ausführungsformen der erfindungsgemäßen Durchflusszellenbaugruppe ist dadurch gekennzeichnet, dass der Dichtungskopf wenigstens ein Dichtungselement, vorzugsweise wenigstens zwei Dichtungselemente, insbesondere wenigstens drei Dichtungselemente, entlang der longitudinalen Achse der Flusszelle aufweist, wobei die Dichtungselemente zwischen einer inneren Wand der Flusszelle und einer äußeren Wand des Dichtungskopfes angeordnet sind.

Durch das wenigstens eine Dichtungselement kann die Abdichtung zwischen dem Dichtungskopf und der Flusszelle noch weiter verbessert und die Durchflusszellenbaugruppe problemlos bei noch höheren Drücken betrieben werden. Weiterhin kann das wenigstens eine Dichtungselement die Position des Dichtungskopfs in der Flusszelle zusätzlich stabilisieren, da das Dichtungselement durch den Druck, den es auf die innere Wand der Flusszelle und auf die äußere Wand des Dichtungskopfes ausübt, für eine zusätzliche Verklemmung von Dichtungskopf und Flusszelle sorgt.

Bei bevorzugten Weiterbildungen dieser Klasse von Ausführungsformen ist wenigstens ein Dichtungselement als Profildichtung oder Konturdichtung ausgebildet.

Dies ist in der Praxis besonders einfach und kostengünstig umzusetzen bei einer gleichzeitig hinreichend guten Dichtungswirkung.

Weiterhin bevorzugt sind Weiterbildungen dieser Klasse von Ausführungsformen der erfindungsgemäßen Durchflusszellenbaugruppe, die sich dadurch auskennzeichnen, dass der Dichtungskopf in einem Bereich des Dichtungselements wenigstens eine ringförmig umlaufende Nut aufweist, in welcher ein Dichtring aufgenommen werden kann.

Durch die Nut wird eine definierte mechanische Führung für das Dichtungselement zur Verfügung gestellt. Der Dichtring kann einfach in die ringförmig umlaufende Nut eingesetzt werden und verbleibt dann in der Nut. Das Einführen des Anschlussstücks mit dem Dichtungskopf in die Flusszelle kann auf diese Weise weiter vereinfacht werden, da der Dichtring durch die Nut gehalten wird und beim Einführen in die Flusszelle nicht aus seiner Position geschoben werden kann.

Ebenso bevorzugt sind Weiterbildungen dieser Klasse von Ausführungsformen, bei denen wenigstens ein Dichtungselement einen elastischen oder flüssigen Dichtwerkstoff aufweist.

Dies ist in der Praxis besonders einfach und kostengünstig umzusetzen. Der elastische oder flüssige Dichtwerkstoff kann sich gleichmäßig zwischen dem Dichtungskopf und der Flusszelle verteilen. Weiterhin ist es möglich, das Anschlussstück permanent mit der Flusszelle zu verbinden.

Weitere bevorzugte Ausführungsformen der erfindungsgemäßen Durchflusszellenbaugruppe sind dadurch gekennzeichnet, dass ein Anschlussdurchmesser dₐₙₛ des Dichtungskopfes des Anschlussstückes größer ist als ein Außendurchmesser dₐᵤₛₛ eines Dichtungshalses des Anschlussstückes.

Hierdurch kann das Anschlussstück problemlos in der Durchflusszelle angebracht werden und der Dichtungshals durch die erste Öffnung der Flusszelle hindurchgeführt werden. Für die Durchmesser der Durchflusszellenbaugruppe gilt allgemein dinn ≥ d_{dicht} > d_{off} > dₐₙₛ > dₐᵤₛₛ.

Weiterhin bevorzugt sind Ausführungsformen der erfindungsgemäßen Durchflusszellenbaugruppe, bei denen der Außendurchmesser dₐᵤₛₛ des Dichtungshalses des Anschlussstücks kleiner ist als ein Flusszellenaußendurchmesser d_{fad} der Flusszelle. Hierdurch kann die Durchflusszellenbaugruppe auch in einen NMR-Probenkopf mit einer einseitig verengten Öffnung einbracht werden. Für dₐᵤₛₛ gilt typischerweise dₐᵤₛₛ ≤ 0,9*d_{fad}, bevorzugt dₐᵤₛₛ ≤ 0,75*d_{fad}, besonders bevorzugt dₐᵤₛₛ ≤ 0,6*d_{fad},

Ebenso bevorzugt sind Ausführungsformen der erfindungsgemäßen Durchflusszellenbaugruppe, bei denen das Anschlussstück in einem Bereich außerhalb der Flusszelle eine Öffnung mit einem Aufnahmedurchmesser d_{auf} zur Aufnahme einer Durchflussleitung aufweist.

Eine Durchflussleitung kann in die Öffnung mit dem Aufnahmedurchmesser d_{auf} eingeführt werden. Typischerweise entspricht der Aufnahmedurchmesser d_{auf} ungefähr dem äußeren Durchmesser der Durchflussleitung, damit die Durchflussleitung passgenau in die Öffnung eingesetzt werden und somit keine flüssige NMR-Probe aus der Öffnung austreten kann.

Der Aufnahmedurchmesser d_{auf} kann so angepasst werden, dass Durchflussleitungen unterschiedlicher Größe an das Anschlussstück angeschlossen werden können. Typischerweise ist der Aufnahmedurchmesser d_{auf} etwa halb so groß wie der äußere Durchmesser des Dichtungshalses, um eine gute Stabilität des Anschlussstücks zu gewährleisten.

Bei weiteren, ganz besonders bevorzugten Klassen von Ausführungsformen der erfindungsgemäßen Durchflusszellenbaugruppe ist vorgesehen, dass der Dichtungskopf des Anschlussstücks in einem Bereich innerhalb der Flusszelle eine Öffnung mit einem Weiterleitungsdurchmesser d_{weit} zur Weiterleitung der flüssigen NMR-Probe aufweist.

Der Weiterleitungsdurchmesser d_{weit} kann flexibel angepasst werden. Typischerweise kann für den Weiterleitungsdurchmesser d_{weit} gelten, dass d_{weit} ≈ 0,2*dᵢₙₙ beträgt.

Weiterhin bevorzugt sind Weiterbildungen dieser Klasse von Ausführungsformen, die sich dadurch auskennzeichnen, dass für den Aufnahmedurchmesser d_{auf} und den Weiterleitungsdurchmesser d_{weit} gilt: d_{weit} < d_{auf}. Hierdurch kann bei der Einführung einer Durchflussleitung ein fester Anschlag definiert werden.

Ebenfalls bevorzugt sind Ausführungsformen der erfindungsgemäßen Durchflusszellenbaugruppe, bei denen ein Innenleitungsdurchmesser d_{ild} einer Verbindungsleitung im Dichtungskopf des Anschlussstücks größer ist als ein Außenleitungsdurchmesser d_{ald} der Verbindungsleitung.

Die Verbindungsleitung umfasst einen Bereich mit einem Innenleitungsdurchmesser d_{ild} und einem Außenleitungsdurchmesser d_{ald}. Der Außenleitungsdurchmesser d_{ald} ist ungefähr auf den Durchmesser der Durchflussleitung abgestimmt. Durch den größeren Innenleitungsdurchmesser d_{ild} kann die flüssige NMR-Probe besser in die Flusszelle eingebracht werden und ein gleichmäßiger Strom an flüssiger Probensubstanz zur Verfügung gestellt werden. Außerdem kann eine stufenweise Reduzierung der Strömungsgeschwindigkeit der flüssigen NMR-Probe beim Übergang von einer Durchflussleitung zum Inneren der Flusszelle erreicht werden.

Bevorzugt sind auch Ausführungsformen der erfindungsgemäßen Durchflusszellenbaugruppe, die dadurch gekennzeichnet sind, dass die Durchflusszellenbaugruppe für einen inneren Druck von wenigstens 10⁶ Pa, vorzugsweise wenigstens 1,5·10⁶ Pa, insbesondere wenigstens 2·10⁶ Pa , ausgebildet ist. Bei einer auf diese Drücke ausgelegten Flusszelle kann die flüssige NMR-Probe zügig durch die Flusszelle befördert werden. Ebenso kann die Qualität bei NMR-Messungen durch den beständigen Strom der flüssigen Probensubstanz verbessert werden. Große Drücke sind insbesondere bei mit NMR-Messungen zu überwachenden schnellen Reaktionen erforderlich, da nur hierdurch die flüssige NMR-Probe aus dem Reaktionsgefäß schnell zum Bereich der NMR-Messung im NMR-Spektrometer befördert werden kann.

In den Rahmen der vorliegenden Erfindung fällt auch ein NMR-Spektrometer zur Messung von NMR-Proben, umfassend
- eine Durchflusszellenbaugruppe wie oben beschrieben,
- einer Magnetbohrung in einer NMR-Magnetanordnung, und
- einen Probenhalter innerhalb der Magnetbohrung für ein reversibles Einsetzen der Durchflusszellenbaugruppe.

Die zahlreichen Vorteile der erfindungsgemäßen Durchflusszellenbaugruppe kommen in der Praxis besonders gut bei einem derartigen Aufbau eines NMR-Spektrometers zur Geltung.

Eine bevorzugte Klasse von Ausführungsformen des erfindungsgemäßen NMR-Spektrometers ist dadurch gekennzeichnet, dass ein durch die NMR-Magnetanordnung erzeugtes NMR-Magnetfeld quer, insbesondere rechtwinklig zu einer Achse der Magnetbohrung verläuft.

Da keine das NMR-Magnetfeld störende Durchflussleitung in der Flusszelle angeordnet ist, können auch in diesem Fall qualitativ gute Messungen erhalten werden.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: einen Ausschnitt eines schematischen Längsschnitts einer erfindungsgemäßen Durchflusszellenbaugruppe mit einer teilweise dargestellten Flusszelle und einem Anschlussstück;
- Fig. 2: den schematischen Längsschnitt der erfindungsgemäßen Durchflusszellenbaugruppe aus Fig. 1 mit und ohne Schraffuren zur Verdeutlichung der Flussräume für eine flüssige NMR-Probe; und
- Fig. 3: einen schematischen Messaufbau zur Durchführung einer NMR-Messung mit einem NMR-Spektrometer und der erfindungsgemäßen Durchflusszellenbaugruppe.

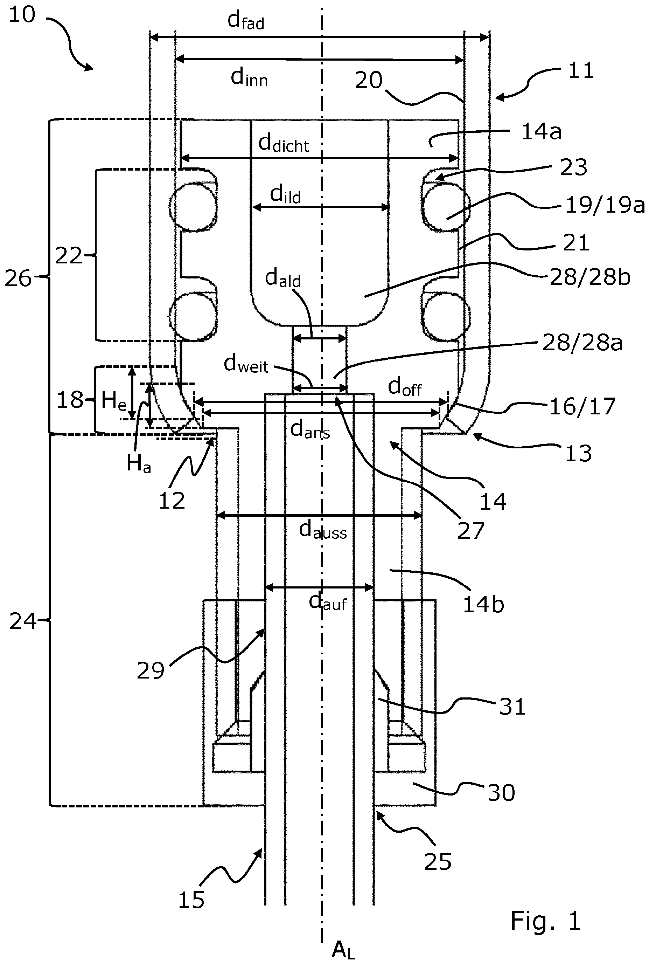

In **Fig. 1** ist ein schematischer Längsschnitt eines Ausschnitts einer erfindungsgemäßen **Durchflusszellenbaugruppe 10** gezeigt, wie sie in einem NMR-Spektrometer zur NMR-Messung einer flüssigen NMR-Probe, verwendet werden kann. Die Durchflusszellenbaugruppe 10 erstreckt sich entlang einer **longitudinalen Achse A_{L}.**

Die Durchflusszellenbaugruppe 10 umfasst eine **Flusszelle 11** ("Sampleglas"), in welcher die flüssige NMR-Probe aufgenommen wird. Die Flusszelle 11 ist im Wesentlichen zylinderförmig ("zylindrisch") ausgebildet mit einem **Flusszellenaußendurchmesser d_{fad}** von ungefähr 5 mm, einem **inneren Flusszellendurchmesser dᵢₙₙ** von ungefähr 4 mm und einer Gesamtlänge entlang der longitudinalen Achse A_{L} von ungefähr 180 mm (in Fig. 1 ist lediglich ein unterer Abschnitt der Flusszelle 11 von etwa 10 mm Länge dargestellt). In der hier gezeigten Ausführungsform ist die Flusszelle 11 aus Borosilicatglas 3.3 gefertigt.

Eine **erste Öffnung 12** mit einem **Öffnungsdurchmesser d_{off}** von ungefähr 3,5 mm (also ca. 87% des inneren Flusszellendurchmessers dᵢₙₙ) ist an **einem ersten Ende 13** der Flusszelle 11 ausgebildet und eine zweite Öffnung ist an einem zweiten Ende der Flusszelle 11 ausgebildet (nicht näher dargestellt). Die Verjüngung des inneren Flusszellendurchmessers dᵢₙₙ auf den Öffnungsdurchmesser d_{off} erfolgt entlang der longitudinalen Achse A_{L} über eine **Höhe Hₑ** von ungefähr 0,7 mm (also etwas weniger als 0,5% der Gesamtlänge der Flusszelle 11).

Hinsichtlich der ersten Öffnung 12 am ersten Ende 13 und der zweiten Öffnung am zweiten Ende ist die Flusszelle 11 beim gezeigten Ausführungsbeispiel nicht symmetrisch aufgebaut. Das heißt, die erste Öffnung 12 und die zweite Öffnung sind in ihrer Ausformung nicht identisch. In der hier gezeigten Ausführungsform ist die zweite Öffnung am zweiten Ende der Flusszelle 11 ohne Verjüngung ausgestaltet (nicht näher dargestellt). In weiteren hier nicht gezeigten Ausführungsformen ist es auch möglich, dass sich die zweite Öffnung am zweiten Ende der Flusszelle 11 verbreitert.

Die Durchflusszellenbaugruppe 10 umfasst weiterhin ein **Anschlussstück 14,** welches bei der ersten Öffnung 12 am ersten Ende 13 der Flusszelle 11 angeordnet ist. Das Anschlussstück 14 wird in einen **Dichtungskopf 14a** (auch als "Zapfen" oder "Kupplung" bezeichnet) und in einen **Dichtungshals 14b** unterteilt. Ein **Dichtungskopfdurchmesser** d_{dicht} des Dichtungskopfes 14a beträgt etwa 3,9 mm und ist somit minimal kleiner als der innere Flusszellendurchmesser dᵢₙₙ (=4 mm) der Flusszelle 11. Ein **Außendurchmesser dₐᵤₛₛ** des Dichtungshalses 14b beträgt etwa 2,75 mm und ist somit kleiner als der Öffnungsdurchmesser d_{off} (=3,5 mm) der Flusszelle 11. Der Dichtungskopf 14a mit dem Dichtungskopfdurchmesser d_{dicht} von 3,9 mm verjüngt sich beim Übergang zum Dichtungshals 14b über eine **Höhe Hₐ** des Anschlussstücks 14 von ungefähr 0,6 mm auf einen **Anschlussdurchmesser dₐₙₛ** von ungefähr 3,4 mm.

In der hier gezeigten Ausführungsform ist dᵢₙₙ (= 4 mm) ≥ d_{dicht} (= 3,9 mm) > d_{off} (= 3,5 mm) > dₐₙₛ (= 3,4 mm) > dₐᵤₛₛ (= 2,75 mm). Hierdurch wird ein sicheres Einführend des Anschlussstücks 14 ermöglicht und die Durchflusszelle 11 und das Anschlussstück 14 bilden einen dichten Formschluss aus.

Zur Fertigung der Durchflusszellenbaugruppe 10 wird das Anschlussstück 14 in die Flusszelle 11 eingeführt. Dies ist möglich, da der Außendurchmesser dₐᵤₛₛ des Dichtungshalses 14b von 2,75 mm kleiner und der Dichtungskopfdurchmesser d_{dicht} des Dichtungskopfes 14a von 3,9 mm geringfügig kleiner ist als der innere Flusszellendurchmesser dᵢₙₙ der Flusszelle 11 von 4 mm. Die erste Öffnung 12 mit dem Öffnungsdurchmesser d_{off} von 3,5 mm ist groß genug, sodass der Dichtungshals 14b mit dem Außendurchmesser dₐᵤₛₛ von 2,75 mm aus der Flusszelle 11 hinaus geführt werden kann, während der Dichtungskopf 14a in der Flusszelle 11 verbleibt und mit der Flusszelle 11 einen Formschluss bildet. Der Anschlussdurchmesser dₐₙₛ des Dichtungskopfes 14a von 3,4 mm ist geringfügig kleiner als der Öffnungsdurchmesser d_{off} (=3,5 mm) der ersten Öffnung 12 am ersten Ende 13 der Flusszelle 11. Der Dichtungskopf 14a kann also nicht über die erste Öffnung 12 der Flusszelle 11 hinausgeschoben werden, da der Dichtungskopfdurchmesser d_{dicht} größer ist als der Öffnungsdurchmesser d_{off} der ersten Öffnung 12.

Das Anschlussstück 14 weist in der hier gezeigten Ausführungsform ungefähr eine Länge von 10 mm entlang der longitudinalen Achse A_{L} auf. Der Dichtungskopf 14a nimmt einen **Bereich 26** innerhalb der Flusszelle 11 ein, wobei die Länge des Dichtungskopfes 14a entlang der longitudinalen Achse ungefähr 4,5 mm entspricht. Der Dichtungshals 14b nimmt einen **Bereich 24** außerhalb der Flusszelle 11 ein, wobei die Länge des Dichtungshalses 14b entlang der longitudinalen Achse ungefähr 5,5 mm entspricht.

In einem **Bereich 18** der ersten Öffnung 12 befindet sich sowohl die Verjüngung der Flusszelle 11 als auch die Verjüngung des Dichtungskopfes 14a. Eine **Außenkontur 16** des Dichtungskopfes 14a ist in der hier gezeigten Ausführungsform dabei so ausgebildet, dass sie im Wesentlichen einer **Innenkontur 17** der Flusszelle 11 entspricht. Auf diese Weise wird ein besonders stabiler Formschluss erreicht und die Abdichtung zwischen Flusszelle 11 und Anschlussstück 14 verbessert.

Der Dichtungskopf 14a umfasst zwei **Dichtungselemente 19.** Die Dichtungselemente 19 sind in der hier gezeigten Ausführungsform als zwei **Dichtringe 19a** ausgebildet. Die Dichtringe 19a sind entlang der longitudinalen Achse A_{L} zwischen einer **inneren Wand 20** der Flusszelle und einer **äußeren Wand 21** des Dichtungskopfes 14a angeordnet und in einer **ringförmig umlaufenden Nut 23** eingelassen. Durch die Nut 23 können die Dichtringe 19a sicher am Dichtungskopf 14a angebracht werden. Die Nut 23 erstreckt sich über einen **Bereich 22,** der ungefähr den mittleren Bereich entlang der longitudinalen Achse A_{L} im Dichtungskopf 14a umfasst. In weiteren, hier nicht gezeigten Ausführungsformen kann auch nur ein Dichtungselement 19 oder drei Dichtungselemente 19 vorhanden sein. Die Dichtungselemente 19 verbessern zum einen die Abdichtung zwischen Flusszelle 11 und Anschlussstück 14 und sorgen außerdem für eine zusätzliche Verklemmung des Dichtungskopfes 14a in der Flusszelle 11.

Weiterhin umfasst der Dichtungskopf 14a eine **Verbindungsleitung 28** mit einer **Außenleitung 28a** und einer **Innenleitung 28b.** In der hier gezeigten Ausführungsform ist die Verbindungsleitung 28 im Wesentlichen zylinderförmig ausgebildet und hat entlang der longitudinalen Achse A_{L} eine Länge von ungefähr 4 mm. Die Außenleitung 28a hat einen **Außenleitungsdurchmesser d_{ald}** von ungefähr 0,8 mm und entlang der longitudinalen Achse A_{L} eine Länge von ungefähr 1 mm. Die Innenleitung 28b hat einen **Innenleitungsdurchmesser d_{ild}** von ungefähr 2 mm und entlang der longitudinalen Achse A_{L} eine Länge von ungefähr 3 mm.

Über die Außenleitung 28a wird eine flüssige NMR-Probe von der ersten Öffnung 12 weiter in die Innenleitung 28b und von dort in die Flusszelle 11 geleitet. Durch den größeren Innenleitungsdurchmesse d_{ild} der Verbindungsleitung 28 durchfließt die flüssige NMR-Probe die Flusszelle 11 in einem gleichmäßigen Strom. Die gerundete Konturerweiterung beim Übergang von der Außenleitung 28a zur Innenleitung 28b sorgt weiterhin für eine gleichmäßigen Fluss der flüssigen NMR-Probe aus der Flusszelle 11 heraus oder in diese hinein.

Der Dichtungshals 14b des Anschlussstücks 14 umfasst eine **Öffnung 25** mit einem **Aufnahmeraum 29** zur Aufnahme einer **Durchflussleitung 15** (auch als "Kapillare", "Zulaufkapillare" oder "Zulaufleitung" bezeichnet) und weiterhin eine **Hülse 30** mit einem **Klemmring 31.** Die Öffnung 25 ist außerhalb der Flusszelle 11 ausgebildet und weist in der hier gezeigten Ausführungsform einen **Aufnahmedurchmesser d_{auf}** von ungefähr 1,6 mm auf. Der Aufnahmeraum hat entlang der longitudinalen Achse A_{L} eine Länge von ungefähr 6 mm.

Die Durchflussleitung 15, deren Durchmesser minimal kleiner als der Aufnahmedurchmesser d_{auf} ist, ist in der hier gezeigten Ausführungsform in den Aufnahmeraum 29 komplett eingeführt. Über die Hülse 30 mit dem Klemmring 31 wird die Durchflussleitung 15 im Aufnahmeraum verklemmt und kann so stabil in Position gehalten werden. Auf diese Weise wird eine fluiddichte Verbindung der Durchflussleitung 15 über das Anschlussstück 14 mit der Flusszelle 11 erreicht. Da die Durchflussleitung nur verklemmt ist, kann diese auf einfache Weise aus dem Anschlussstück 14 entfernt werden.

In der hier gezeigten Ausführungsform weist der Dichtungskopf 14a eine **Öffnung 27** auf, über die die flüssige NMR-Probe von der Durchflussleitung 15 weiter in die Flusszelle 11 geleitet wird. Öffnung 27 ist im Bereich 26 der Flusszelle angeordnet und Öffnung 26 weist einen **Weiterleitungsdurchmesser d_{weit}** von ungefähr 0,8 mm auf. Über Öffnung 27 ist zugleich die Außenleitung 28a der Verbindungsleitung 28 zugängig. In der hier gezeigten Ausführungsform entspricht der Weiterleitungsdurchmesser d_{weit} der Öffnung 27 im Wesentlichen dem Außenleitungsdurchmesser d_{ald} (=0,8 mm) der Verbindungsleitung 28. In der hier gezeigten Ausführungsform entspricht ein innerer Durchmesser der Durchflussleitung 15 im Wesentlichen dem Weiterleitungsdurchmesser d_{weit}.

Die Durchflussleitung 15 ist in der hier gezeigten Ausführungsform aus Quarzglas, also einem starren Material, gefertigt. Weiterhin ist es möglich, dass die Durchflussleitung 15 komplett aus einem flexiblen Material wie etwa Silikon gefertigt ist, oder dass die Durchflussleitung 15 im Bereich des Anschlussstücks 14 aus einem starren Material gefertigt ist und der Rest der Durchflussleitung 15 aus einem flexiblen Material gefertigt ist.

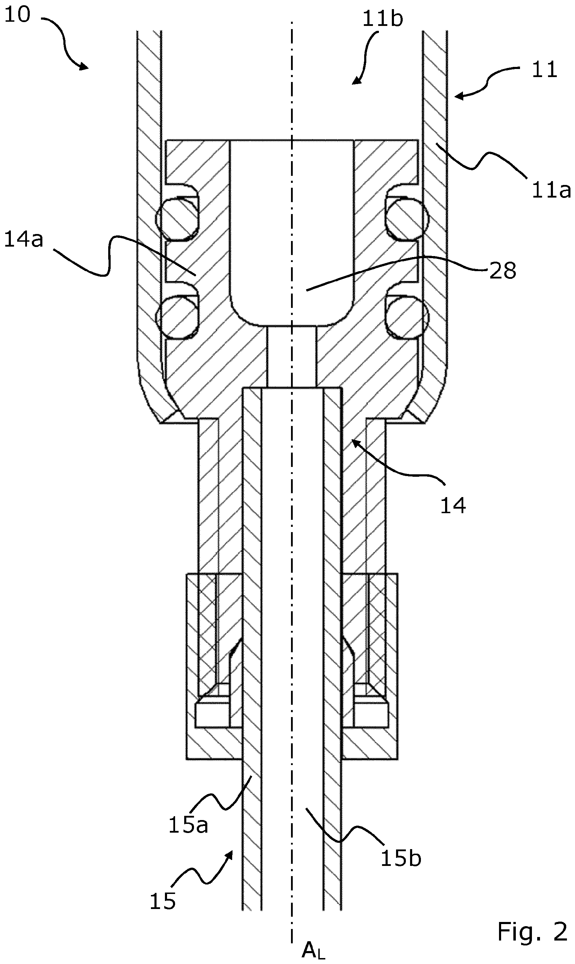

**Fig. 2** zeigt den schematischen Längsschnitt der erfindungsgemäßen Durchflusszellenbaugruppe 10 aus Fig. 1 mit und ohne Schraffuren zur Verdeutlichung der Flussräume für eine flüssige NMR-Probe.

Die Flusszelle 11 umfasst eine **Flusszellenwand 11a** (schraffierter Bereich), die einen hier ungefüllten **Flusszelleninnenraum 11b** (unschraffierter Bereich) gegenüber der Umgebung abgrenzt. In der hier gezeigt Ausführungsform ist im Flusszelleninnenraum 11b der Dichtungskopf 14a des Anschlussstücks 14 angeordnet. Im restlichen Flusszellenraum kann die flüssige NMR-Probe geführt werden.

Das Anschlussstück 14 (schraffierter Bereich) umfasst die Verbindungsleitung 28, die in der hier gezeigten Form ungefüllt ist (unschraffierter Bereich). In der hier gezeigten Ausführungsform ist Verbindungsleitung 28 mit der Durchflussleitung 15 verbunden. Die Durchflussleitung 15 umfasst eine **Leitungswand 15a** (schraffierter Bereich), die einen hier ungefüllten **Leitungsinnenraum 15b** (unschraffierter Bereich) gegenüber der Umgebung und dem Anschlussstück 14 abgrenzt.

Bei einer NMR-Messung wird die flüssige NMR-Probe über den Leitungsinnenraum 15b der Durchflussleitung 15 zur Verbindungsleitung 28 des Anschlussstücks 14 geleitet und von dort dann weiter in den Flusszelleninnenraum 11b der Flusszelle 11. An der zweiten Öffnung am zweiten Ende der Flusszelle 11 (nicht näher dargestellt) wird die flüssige NMR-Probe dann aus dem Flusszelleninnenraum 11b heraus abgeführt. Die Flussrichtung kann jedoch auch umgekehrt von der zweiten Öffnung hin zur ersten Öffnung 12 und dann durch das Anschlussstück 14 in eine Durchflussleitung 15 verlaufen.

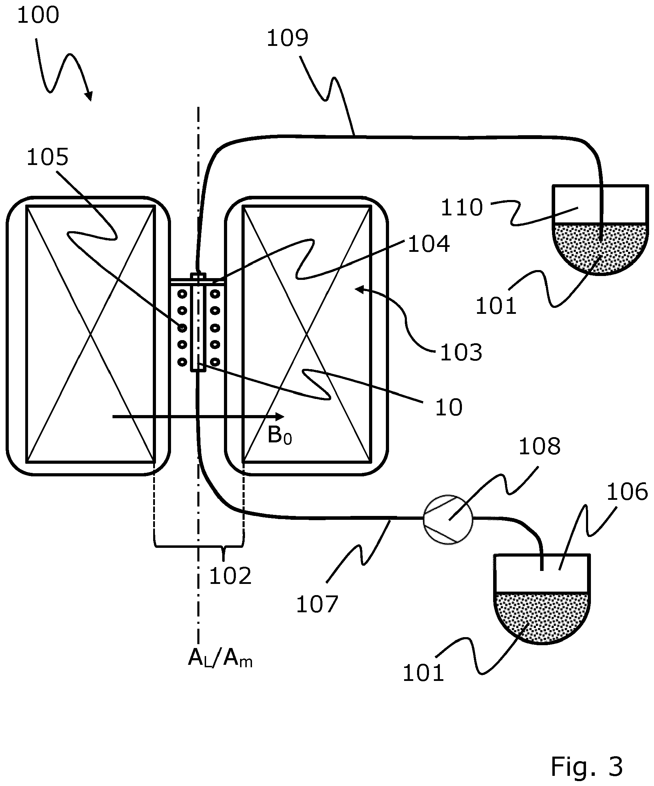

In **Fig. 3** ist ein schematischer Messaufbau zur Durchführung einer NMR-Messung einer flüssigen **NMR-Probe 101** mit einem **NMR-Spektrometer 100** und der erfindungsgemäßen Durchflusszellenbaugruppe 10 dargestellt.

Das NMR-Spektrometer 100 umfasst eine **NMR-Magnetanordnung 103** mit einer **Magnetbohrung 102,** einen **Probenhalter 104,** und eine **RF(=Radiofrequenz)-Spule 105** zur Anregung und Detektion eines NMR-Signals der flüssigen NMR-Probe 101, und der erfindungsgemäßen Durchflusszellenbaugruppe 10, die in den Probenhalter 104 des NMR-Spektrometers 100 eingeführt ist. Die Durchflusszellenbaugruppe 10 erstreckt sich entlang der longitudinalen Achse A_{L} und die Magnetbohrung 102 erstreckt sich entlang einer **Achse Aₘ,** wobei in der hier gezeigten Ausführungsform die longitudinale Achse A_{L} und die Achse Aₘ der Magnetbohrung 102 im Wesentlichen identisch sind. In der hier gezeigten Ausführungsform steht ein **NMR-Magnetfeld B₀** rechtwinklig zur longitudinalen Achse A_{L}. In weiteren, hier nicht gezeigten Ausführungsformen ist es allerdings auch möglich, dass das NMR-Magnetfeld B₀ beispielsweise parallel zur longitudinalen Achse A_{L} steht.

Die Durchflusszellenbaugruppe 10 ist an ein **erstes Reservoir 106** über eine **Zulaufleitung 107** angeschlossen, wobei die Zulaufleitung 107 mit der Durchflusszellenbaugruppe 10 über das Anschlussstück verbunden wird. An die Zulaufleitung 107 ist eine **Pumpe 108** angeschlossen. Über eine **Abflussleitung 109** ist die Durchflusszellenbaugruppe 10 mit einem **zweiten Reservoir 110** verbunden.

Im ersten Reservoir 106 befindet sich die flüssige NMR-Probe 101, die gemessen werden soll. Mit Hilfe der Pumpe 108 wird die flüssige NMR-Probe 101 über die Zulaufleitung 107 zur Durchflusszellenbaugruppe 10 geleitet. Von dort wird die flüssige NMR-Probe dann über die Abflussleitung 109 in das zweite Reservoir 110 geleitet.

### Messung von NMR-Proben

Die Messung der NMR-Probe 101 mit Hilfe des NMR-Spektrometers 100 und der Durchflusszellenbaugruppe 10 kann auf folgende Weise erfolgen:
Die Durchflusszellenbaugruppe 10 wird zusammengesetzt, indem das Anschlussstück mit den in Fig. 1 beschriebenen Komponenten in die Flusszelle eingeführt wird. Anschlussstück und Flusszelle bilden an der ersten Öffnung einen Formschluss. An das Anschlussstück wird die Durchflussleitung, die hier als Zulaufleitung 107 ausgebildet ist, fluiddicht angeschlossen, wobei über die Zulaufleitung 107 die flüssige NMR-Probe 101 zugeleitet werden kann. An das zweite Ende der Durchflusszelle wird die Ablaufleitung 109 angebracht.

Die Durchflusszellenbaugruppe 10 wird in das NMR-Spektrometer 100 mit der Magnetbohrung 102, die den Probenhalter 104 für die Durchflusszellenbaugruppe 10 aufweist, eingesetzt. Die Magnetbohrung 102 wiederum ist in einer NMR-Magnetanordnung 103 angeordnet. Da die Durchflusszellenbaugruppe 10 in einem Messbereich der Flusszelle 11 keine weiteren Bauteile wie etwa eine ein Magnetfeld störende Durchflussleitung aufweist, ist es im Wesentlichen unerheblich, in welche Richtung das durch die NMR-Magnetanordnung 103 erzeugte NMR-Magnetfeld B₀ zeigt. Das heißt, dass die Erfindung sowohl bei NMR-Spektrometern 100 eingesetzt werden kann, bei denen das Magnetfeld B₀ parallel zur Magnetbohrung 102 (und damit parallel zur longitudinalen Achse A_{L} der Flusszelle) ist, als auch bei NMR-Spektrometern 100, bei denen das Magnetfeld B₀ quer zur Magnetbohrung 102 (und damit quer zur longitudinalen Achse A_{L} der Flusszelle) verläuft.

Nachdem die Durchflusszellenbaugruppe 10 in das NMR-Spektrometer 100 eingesetzt ist, wird die NMR-Messung gestartet. Bei der NMR-Messung kann es sich um eine Einzelmessung oder um eine kontinuierliche Messung handeln, beispielsweise um eine chemische Reaktion in Echtzeit nachzuverfolgen.

Die flüssige NMR-Probe 101 wird während der NMR-Messung aus dem ersten Reservoir 106 mit Hilfe der Pumpe 108 über die Zulaufleitung 107 zur Verbindungsleitung geleitet. Von der Verbindungsleitung aus fließt die flüssige NMR-Probe 101 in die Flusszelle und von dort entlang der longitudinalen Achse A_{L} zur Abflussleitung 109 an der ersten Öffnung der Flusszelle. Die flüssige NMR-Probe 101 fließt dabei in der hier gezeigten Ausführungsform einmal in eine Richtung die Flusszelle. Über die Abflussleitung 109 wird die flüssige NMR-Probe 101 dann aus der Flusszelle in das zweite Reservoir 110 geleitet.

Nach Abschluss der NMR-Messung wird die Durchflusszellenbaugruppe 10 aus dem Probenhalter 104 des NMR-Spektrometers 100 entfernt. Die Zulaufleitung 107 wird dann vom Anschlussstück und die Abflussleitung 108 wird vom zweiten Ende der Durchflusszelle entfernt. Die Durchflusszellenbaugruppe 10 kann dann gereinigt, auseinander gebaut oder für eine weitere NMR-Messung verwendet werden.

Die Durchflusszellenbaugruppe 10 hält Drücken von bis zu 20 bar, die durch die einfließende flüssige NMR-Probe verursacht werden, problemlos stand. Gleichzeitig wird eine gute Abdichtung zwischen Flusszelle und Anschlussstück erreicht, sodass keine flüssige NMR-Probe 101 aus der Durchflusszellenbaugruppe 10 austritt und dadurch die NMR-Messung unbrauchbar macht oder das NMR-Spektrometer 100 durch die flüssige NMR-Probe 101 verunreinigt oder beschädigt wird.

### Bezugszeichenliste:

- 10: Durchflusszellenbaugruppe
- 11: Flusszelle
- 11a: Flusszellenwand
- 12b: Flusszelleninnenraum
- 12: erste Öffnung
- 13: erstes Ende
- 14: Anschlussstück
- 14a: Dichtungskopf
- 14b: Dichtungshals
- 15: Durchflussleitung
- 15a: Leitungswand
- 15b: Leitungsinnenraum
- 16: Außenkontur
- 17: Innenkontur
- 18: Bereich (der ersten Öffnung)
- 19: Dichtungselement
- 19a: Dichtring
- 20: innere Wand
- 21: äußere Wand
- 22: Bereich (des Dichtungselements)
- 23: ringförmig umlaufende Nut
- 24: Bereich (außerhalb der Flusszelle)
- 25: Öffnung (mit Aufnahmedurchmesser d_{auf})
- 26: Bereich (innerhalb der Flusszelle)
- 27: Öffnung (mit Weiterleitungsdurchmesser d_{weit})
- 28: Verbindungsleitung
- 28a: Außenleitung
- 28b: Innenleitung
- 29: Aufnahmeraum
- 30: Hülse
- 31: Klemmring
- 100: NMR-Spektrometer
- 101: (flüssige) NMR-Probe
- 102: Magnetbohrung
- 103: NMR-Magnetanordnung
- 104: Probenhalter
- 105: RF-Spule
- 106: erstes Reservoir (für Zulauf)
- 107: Zulaufleitung
- 108: Pumpe
- 109: Abflussleitung
- 110: zweites Reservoir (für Ablauf)

- A_{L}: longitudinale Achse
- Aₘ: Achse (der Magnetbohrung)
- B₀: NMR-Magnetfeld
- d_{ald}: Außenleitungsdurchmesser
- dₐₙₛ: Anschlussdurchmesser
- d_{auf}: Aufnahmedurchmesser
- dₐᵤₛₛ: Außendurchmesser
- d_{dicht}: Dichtungskopfdurchmesser
- d_{fad}: Flusszellenaußendurchmesser
- d_{ild}: Innenleitungsdurchmesser
- dᵢₙₙ: innerer Flusszellendurchmesser
- d_{off}: Öffnungsdurchmesser
- d_{weit}: Weiterleitungsdurchmesser
- Hₐ: Höhe (der Verjüngung des Anschlussstücks)
- Hₑ: Höhe (der ersten Öffnung)

### Referenzliste

Für die Beurteilung der Patentfähigkeit in Betracht gezogene Publikationen:
[0] US 4 827 761 A
[1] US 2006/0 091 885 A1
[2] US 2016/0 290 941 A1
[3] US 2005 / 0 052 184 A1
[4] US 6 396 274 B1
[5] InsightMR, Bruker Corporation, Billerica, Massachusetts, USA
[6] Insight 2.0, Bruker Corporation, Billerica, Massachusetts, USA
[7] Magritek GmbH, Aachen, Nordrhein-Westfalen, DE
[8] JP 2003 075 523 A
[9] DE 10 2017 120 510 B3

## Patentansprüche

1. Durchflusszellenbaugruppe (10) zur Nutzung in einem NMR-Spektrometer (100) für die Durchführung von NMR-Messungen an einer flüssigen NMR-Probe (101), umfassend
- eine Flusszelle (11) zur Aufnahme der NMR-Probe (101), wobei die Flusszelle (11) eine erste Öffnung (12) an einem ersten Ende (13) der Flusszelle (11) und eine zweite Öffnung an einem zweiten Ende ausbildet, und wobei die Flusszelle (11) entlang einer longitudinalen Achse (A_{L}) im Wesentlichen hohlzylinderförmig ist, und
- ein Anschlussstück (14) für die fluiddichte Verbindung einer Durchflussleitung (15) mit der Flusszelle (11), wobei das Anschlussstück (14) bei der ersten Öffnung (12) der Flusszelle (11) angeordnet ist, wobei ein Dichtungskopf (14a) des Anschlussstücks (14) in der ersten Öffnung (12) der Flusszelle (11) angeordnet ist, und wobei ein Dichtungskopfdurchmesser d_{dicht} des Dichtungskopfes (14a) des Anschlussstücks (14) größer ist als ein Öffnungsdurchmesser d_{off} der ersten Öffnung (12) der Flusszelle (11),
**dadurch gekennzeichnet,**
**dass** die hohlzylinderförmige Flusszelle (11) einen Querschnitt aufweist, der sich im Bereich der ersten Öffnung (12) entlang der longitudinalen Achse (A_{L}) kontinuierlich verjüngt, sodass der Öffnungsdurchmesser d_{off} der ersten Öffnung (12) der Flusszelle (11) kleiner ist als ein innerer Flusszellendurchmesser dᵢₙₙ.

2. Durchflusszellenbaugruppe (10) nach Anspruch 1, **dadurch gekennzeichnet, dass** eine Außenkontur (16) des Dichtungskopfes (14a) im Wesentlichen einer Innenkontur (17) der Flusszelle (11) im Bereich (18) der ersten Öffnung (12) gleicht.

3. Durchflusszellenbaugruppe (10) nach Anspruch 1 oder 2, **dadurch gekennzeichnet, dass** der Dichtungskopf (14a) wenigstens ein Dichtungselement (19), vorzugsweise wenigstens zwei Dichtungselemente (19), insbesondere wenigstens drei Dichtungselemente (19), entlang der longitudinalen Achse (A_{L}) der Flusszelle (11) aufweist, wobei die Dichtungselemente (19) zwischen einer inneren Wand (20) der Flusszelle (11) und einer äußeren Wand (21) des Dichtungskopfes (14a) angeordnet sind.

4. Durchflusszellenbaugruppe (10) nach Anspruch 3, **dadurch gekennzeichnet, dass** wenigstens ein Dichtungselement (19) als Profildichtung oder Konturdichtung ausgebildet ist.

5. Durchflusszellenbaugruppe (10) nach Anspruch 3 oder 4, **dadurch gekennzeichnet, dass** der Dichtungskopf (14a) in einem Bereich (22) des Dichtungselements (19) wenigstens eine ringförmig umlaufende Nut (23) aufweist, in der ein Dichtring (19a) aufgenommen werden kann.

6. Durchflusszellenbaugruppe (10) nach einem der Ansprüche 3 bis 5, **dadurch gekennzeichnet, dass** wenigstens ein Dichtungselement (19) einen elastischen oder flüssigen Dichtwerkstoff aufweist.

7. Durchflusszellenbaugruppe (10) nach einem der vorhergehenden Ansprüche, **dadurch gekennzeichnet, dass** ein Anschlussdurchmesser dₐₙₛ des Dichtungskopfes (14a) des Anschlussstückes (14) größer ist als ein Außendurchmesser dₐᵤₛₛ eines Dichtungshalses (14b) des Anschlussstückes (14).

8. Durchflusszellenbaugruppe (10) nach Anspruch 7, **dadurch gekennzeichnet, dass** der Außendurchmesser dₐᵤₛₛ des Dichtungshalses (14b) des Anschlussstücks (14) kleiner ist als ein Flusszellenaußendurchmesser d_{fad} der Flusszelle (11).

9. Durchflusszellenbaugruppe (10) nach einem der vorhergehenden Ansprüche, **dadurch gekennzeichnet, dass** das Anschlussstück (14) in einem Bereich (24) außerhalb der Flusszelle (11) eine Öffnung (25) mit einem Aufnahmedurchmesser d_{auf} zur Aufnahme einer Durchflussleitung (15) aufweist.

10. Durchflusszellenbaugruppe (10) nach Anspruch 9, **dadurch gekennzeichnet, dass** der Dichtungskopf (14a) des Anschlussstücks (14) in einem Bereich (26) innerhalb der Flusszelle eine Öffnung (27) mit einem Weiterleitungsdurchmesser d_{weit} zur Weiterleitung der flüssigen NMR-Probe aufweist.

11. Durchflusszellenbaugruppe (10) nach Anspruch 10, **dadurch gekennzeichnet, dass** für den Aufnahmedurchmesser d_{auf} und den Weiterleitungsdurchmesser d_{weit} gilt: d_{weit} < d_{auf}.

12. Durchflusszellenbaugruppe (10) nach einem der vorhergehenden Ansprüche, **dadurch gekennzeichnet, dass** ein Innenleitungsdurchmesser d_{ild} einer Verbindungsleitung (28) im Dichtungskopf (14a) des Anschlussstücks (14) größer ist als ein Außenleitungsdurchmesser d_{ald} der Verbindungsleitung (28).

13. Durchflusszellenbaugruppe (10) nach einem der vorhergehenden Ansprüche, **dadurch gekennzeichnet, dass** die Durchflusszellenbaugruppe (10) für einen inneren Druck von wenigstens 10⁶ Pa, vorzugsweise wenigstens 1,5·10⁶ Pa, insbesondere wenigstens 2·10⁶ Pa, ausgebildet ist.

14. NMR-Spektrometer (100) zur Messung von NMR-Proben (101), umfassend
- eine Durchflusszellenbaugruppe (10) nach einem der Ansprüche 1 bis 13,
- einer Magnetbohrung (102) in einer NMR-Magnetanordnung (103), und
- einen Probenhalter (104) innerhalb der Magnetbohrung (103) für ein reversibles Einsetzen der Durchflusszellenbaugruppe (10).

15. NMR-Spektrometer (100) nach Anspruch 14, **dadurch gekennzeichnet, dass** das durch die NMR-Magnetanordnung (103) erzeugte NMR-Magnetfeld (B₀) quer, insbesondere rechtwinklig zu einer Achse (Aₘ) der Magnetbohrung (102) verläuft.

## Claims

1. A flow cell assembly (10) for use in an NMR spectrometer (100) for performing NMR measurements on a liquid NMR sample (101), the assembly comprising
- a flow cell (11) for receiving the NMR sample (101), the flow cell (11) forming a first opening (12) at a first end (13) of the flow cell (11) and a second opening at a second end, and the flow cell (11) being substantially hollow-cylindrical along a longitudinal axis (A_{L}), and
- a connecting piece (14) for connecting a flow line (15) to the flow cell (11) in a fluid-tight manner, the connecting piece (14) being arranged at the first opening (12) of the flow cell (11), wherein a sealing head (14a) of the connecting piece (14) is arranged in the first opening (12) of the flow cell (11), and wherein a sealing head diameter d_{dicht} of the sealing head (14a) of the connecting piece (14) is larger than an opening diameter d_{off} of the first opening (12) of the flow cell (11),
**characterized in that**
the hollow-cylindrical flow cell (11) has a cross-section which continuously tapers in the region of the first opening (12) along the longitudinal axis (A_{L}) such that the opening diameter d_{off} of the first opening (12) of the flow cell (11) is smaller than an inner flow cell diameter dᵢₙₙ.

2. The flow cell assembly (10) according to claim 1, **characterized in that** an outer contour (16) of the sealing head (14a) is substantially the same as an inner contour (17) of the flow cell (11) in the region (18) of the first opening (12).

3. The flow cell assembly (10) according to either claim 1 or claim 2, **characterized in that** the sealing head (14a) has at least one sealing element (19), preferably at least two sealing elements (19), in particular at least three sealing elements (19), along the longitudinal axis (A_{L}) of the flow cell (11), the sealing elements (19) being arranged between an inner wall (20) of the flow cell (11) and an outer wall (21) of the sealing head (14a).

4. The flow cell assembly (10) according to claim 3, **characterized in that** at least one sealing element (19) is designed as a profile seal or contour seal.

5. The flow cell assembly (10) according to either claim 3 or claim 4, **characterized in that**, in a region (22) of the sealing element (19), the sealing head (14a) has at least one annular peripheral groove (23) in which a sealing ring (19a) can be accommodated.

6. The flow cell assembly (10) according to one of claims 3 to 5, **characterized in that** at least one sealing element (19) has an elastic or liquid sealing material.

7. The flow cell assembly (10) according to one of the preceding claims, **characterized in that** a connection diameter dₐₙₛ of the sealing head (14a) of the connecting piece (14) is larger than an outer diameter dₐᵤₛₛ of a sealing neck (14b) of the connecting piece (14).

8. The flow cell assembly (10) according to claim 7, **characterized in that** the outer diameter dₐᵤₛₛ of the sealing neck (14b) of the connecting piece (14) is smaller than a flow cell outer diameter d_{fad} of the flow cell (11).

9. The flow cell assembly (10) according to one of the preceding claims, **characterized in that**, in a region (24) outside the flow cell (11), the connecting piece (14) has an opening (25) having a receiving diameter d_{auf} for receiving a flow line (15).

10. The flow cell assembly (10) according to claim 9, **characterized in that**, in a region (26) within the flow cell, the sealing head (14a) of the connecting piece (14) has an opening (27) having a transfer diameter d_{weit} for transferring the liquid NMR sample.

11. The flow cell assembly (10) according to claim 10, **characterized in that** the following applies to the receiving diameter d_{auf} and the transfer diameter d_{weit}: d_{weit} <d_{auf}.

12. The flow cell assembly (10) according to one of the preceding claims, **characterized in that** an inner line diameter d_{ild} of a connecting line (28) in the sealing head (14a) of the connecting piece (14) is greater than an outer line diameter d_{ald} of the connecting line (28).

13. The flow cell assembly (10) according to one of the preceding claims, **characterized in that** the flow cell assembly (10) is designed for an internal pressure of at least 10⁶ Pa, preferably at least 1.5 ·10⁶ Pa, in particular at least 2 · 10⁶ Pa.

14. An NMR spectrometer (100) for measuring NMR samples (101), comprising
- a flow cell assembly (10) according to one of claims 1 to 13,
- a magnet bore (102) in an NMR magnet arrangement (103), and
- a sample holder (104) within the magnet bore (103) for reversible insertion of the flow cell assembly (10).

15. The NMR spectrometer (100) according to claim 14, **characterized in that** the NMR magnetic field (B₀) generated by the NMR magnet arrangement (103) runs transversely, in particular perpendicularly, to an axis (Aₘ) of the magnet bore (102).

## Revendications

1. Ensemble de cellules d'écoulement de passage (10) destiné à être utilisé dans un spectromètre RMN (100) pour effectuer des mesures de RMN sur un échantillon de RMN liquide (101), comprenant
- une cellule d'écoulement (11) pour recevoir l'échantillon de RMN (101), la cellule d'écoulement (11) formant une première ouverture (12) à une première extrémité (13) de la cellule d'écoulement (11) et une seconde ouverture à une seconde extrémité, et la cellule d'écoulement (11) étant sensiblement en forme de cylindre creux le long d'un axe longitudinal (AL), et
- une pièce de raccordement (14) pour une connexion étanche aux fluides d'une conduite d'écoulement de passage (15) à la cellule d'écoulement (11), la pièce de raccordement (14) étant agencée au niveau de la première ouverture (12) de la cellule d'écoulement (11), une tête d'étanchéité (14a) de la pièce de raccordement (14) étant agencée dans la première ouverture (12) de la cellule d'écoulement (11), et un diamètre de tête d'étanchéité d_{dicht} de la tête d'étanchéité (14a) de la pièce de raccordement (14) étant supérieur à un diamètre d'ouverture d_{off} de la première ouverture (12) de la cellule d'écoulement (11),
**caractérisé en ce que**
la cellule d'écoulement (11) de forme cylindrique creuse présente une section transversale qui se rétrécit de manière continue dans la zone de la première ouverture (12) le long de l'axe longitudinal (A_{L}), de sorte que le diamètre d'ouverture d_{off} de la première ouverture (12) de la cellule d'écoulement (11) est inférieur à un diamètre intérieur de cellule d'écoulement dᵢₙₙ.

2. Ensemble de cellules d'écoulement de passage (10) selon la revendication 1, **caractérisé en ce qu'**un contour extérieur (16) de la tête d'étanchéité (14a) ressemble sensiblement à un contour intérieur (17) de la cellule d'écoulement (11) dans la zone (18) de la première ouverture (12).

3. Ensemble de cellules d'écoulement de passage (10) selon la revendication 1 ou 2, **caractérisé en ce que** la tête d'étanchéité (14a) présente au moins un élément d'étanchéité (19), de préférence au moins deux éléments d'étanchéité (19), en particulier au moins trois éléments d'étanchéité (19), le long de l'axe longitudinal (AL) de la cellule d'écoulement (11), les éléments d'étanchéité (19) étant agencés entre une paroi intérieure (20) de la cellule d'écoulement (11) et une paroi extérieure (21) de la tête d'étanchéité (14a).

4. Ensemble de cellules d'écoulement de passage (10) selon la revendication 3, **caractérisé en ce qu'**au moins un élément d'étanchéité (19) est réalisé sous la forme d'un joint profilé ou d'un joint de contour.

5. Ensemble de cellules d'écoulement de passage (10) selon la revendication 3 ou 4, **caractérisé en ce que** la tête d'étanchéité (14a) présente, dans une zone (22) de l'élément d'étanchéité (19), au moins une rainure périphérique annulaire (23) dans laquelle une bague d'étanchéité (19a) peut être reçue.

6. Ensemble de cellules d'écoulement de passage (10) selon l'une quelconque des revendications 3 à 5, **caractérisé en ce qu'**au moins un élément d'étanchéité (19) comprend un matériau d'étanchéité élastique ou liquide.

7. Ensemble de cellules d'écoulement de passage (10) selon l'une quelconque des revendications précédentes, **caractérisé en ce qu'**un diamètre de raccordement dₐₙₛ de la tête d'étanchéité (14a) de la pièce de raccordement (14) est supérieur à un diamètre extérieur dₐᵤₛₛ d'un col d'étanchéité (14b) de la pièce de raccordement (14).

8. Ensemble de cellules d'écoulement de passage (10) selon la revendication 7, **caractérisé en ce que** le diamètre extérieur dₐᵤₛₛ du col d'étanchéité (14b) de la pièce de raccordement (14) est inférieur à un diamètre extérieur de cellule d'écoulement d_{fad} de la cellule d'écoulement (11).

9. Ensemble de cellules d'écoulement de passage (10) selon l'une quelconque des revendications précédentes, **caractérisé en ce que** la pièce de raccordement (14) présente, dans une zone (24) à l'extérieur de la cellule d'écoulement (11), une ouverture (25) avec un diamètre de réception dₛᵤᵣ pour recevoir une conduite d'écoulement de passage (15).

10. Ensemble de cellules d'écoulement de passage (10) selon la revendication 9, **caractérisé en ce que** la tête d'étanchéité (14a) de la pièce de raccordement (14) présente, dans une zone (26) à l'intérieur de la cellule d'écoulement, une ouverture (27) avec un diamètre de transmission d_{weit} pour une transmission de l'échantillon de RMN liquide.

11. Ensemble de cellules d'écoulement de passage (10) selon la revendication 10, **caractérisé en ce que** pour le diamètre de réception d_{auf} et le diamètre de transmission d_{weit} : d_{weit'} < d_{auf}

12. Ensemble de cellules d'écoulement de passage (10) selon l'une quelconque des revendications précédentes, **caractérisé en ce qu'**un diamètre de conduite intérieur d_{ild} d'une conduite de connexion (28) dans la tête d'étanchéité (14a) de la pièce de raccordement (14) est plus grand qu'un diamètre de conduite extérieur d_{ald} de la conduite de connexion (28).

13. Ensemble de cellules d'écoulement de passage (10) selon l'une quelconque des revendications précédentes, **caractérisé en ce que** l'ensemble de cellules d'écoulement de passage(10) est conçu pour une pression interne d'au moins 10^{6·}Pa, de préférence d'au moins 1,5•10⁶ Pa, en particulier d'au moins 2•10⁶ Pa.

14. Spectromètre RMN (100) pour mesurer des échantillons de RMN (101), comprenant
- un ensemble de cellules d'écoulement de passage (10) selon l'une quelconque des revendications 1 à 13,
- un alésage magnétique (102) dans un dispositif magnétique de RMN (103), et
- un porte-échantillon (104) à l'intérieur de l'alésage magnétique (103) pour une insertion réversible de l'ensemble de cellules d'écoulement de passage (10).

15. Spectromètre RMN (100) selon la revendication 14, **caractérisé en ce que** le champ magnétique de RMN (B₀) généré par le dispositif magnétique de RMN (103) s'étend transversalement, en particulier perpendiculairement par rapport à un axe (Aₘ) de l'alésage magnétique (102).
